# EUROPEAN PATENT APPLICATION

(11) **EP 2 448 380 A1**
(43) Date of publication of application: **02.05.2012**
(21) Application number: 10188945.9
(22) Date of filing: 26.10.2010
(51) Int. Cl.: H05K 3/00, H05K 3/10, H05K 3/46

(54) **Composite build-up material for embedding of circuitry**

(71) Applicant: ATOTECH Deutschland GmbH, 10553 Berlin (DE)
(72) Inventor: Bruderer, Alex, 4057, Basel (CH); Galster, Norbert, 4052, Basel (CH); Kress, Jürgen, 4125, Riehen (CH); Probst, Michel, 68170, Rixheim (FR)
(74) Representative: Wonnemann, Jörg

(57) **Abstract**

Disclosed are composite build-up materials for the manufacture of printed circuit boards, IC substrates, chip packages and the like. The composite build-up materials are suitable for embedding circuitry such as microvias, trenches and pads.
The composite build-up materials comprise a carrier layer (1), a reasin layer without reinforcement (2), and a resin layer with reinforcement (3). The circuitry (9) is embedded into the resin layer without reinforcement (2).

## Description

The invention relates to build-up materials for manufacture of printed circuit boards, IC substrates, chip packages and the like, suitable for embedding circuitry to form electrical paths for signal propagation.

### Background of the Invention

Circuitry such as copper tracks (such as copper filled microvias, trenches and pads) are mounted on one or both outer surfaces of substrate materials which are then stacked and laminated to form devices such as printed circuit boards, IC substrates, chip packages and the like. Due to the ongoing demand for size reduction of such devices, circuitry features such as width of copper tracks and the space between two copper tracks have to be reduced further. To achieve this goal conventional methods for manufacture of copper tracks such as roughening the surface of the non-conductive substrate followed by copper deposition onto the substrate surface and print and etch procedures need to be replaced by more fine-line capable manufacturing methods. One of such new manufacturing methods comprises embedding of copper tracks into the non-conductive substrate material, i.e., depositing into features created within the non-conductive substrate material. Such manufacturing methods utilize laser ablation techniques to form features within the substrate material. The advantage of such manufacturing methods are manifold: they overcome the drawback of insufficient adhesion of a copper deposit plated onto an only slightly roughened substrate material and further provide isolation and shielding of copper tracks having a very small space between adjacent copper tracks of for example 10 µm or even less. Said copper tracks comprise microvias, trenches and pads.

The requirements for substrate composite build-up materials suitable for embedding circuitry are manifold. The coefficient of thermal expansion (CTE) of composite build-up materials needs to be as close as possible to those of other materials of a typical build-up, such as metals like copper, and polymers.

Furthermore, the build-up material, more precisely the layers of a build-up material which should later on host the embedded circuitry, need to be structured, i.e., partially ablated with a laser beam prior to copper deposition. Therefore, said build-up material must be able to be ablated by means of a laser beam.

Composite build-up materials used for embedding circuitry are for example resin coated foils (RCF). For the production of high density interconnect (HDI) printed circuit boards having embedded circuitry the use of resin coated foils (RCF) is a standard technique (Printed circuits handbook, Ed. Clyde F. Coombs Jr, 6th ed, chapter 22). First the inner layers of the printed circuit board are manufactured and then the RCF is laminated onto them. This process takes place in vacuum presses. The b-staged resin of the RCF is melting at elevated temperatures and fills the spaces of the copper tracks of the innerlayer. Then the resin is cured at still higher temperature and when the pressing cycle is finished, features such as microvias, trenches and pads are created in the cured resin layer using laser ablation processes.

One advantage of RCFs is the fact that they have a rather low modulus and can therefore absorb mechanical stress from the environment much better than prepregs. This is for example important when it comes to the so-called drop test (JESD22-B111) which assesses the ability of an electronic device to cope with severe mechanical stress. On the other hand the CTE of the RCF material is rather high which is a severe disadvantage, e. g., in thermal cycling tests and solder dip tests (relevant test procedures: JESD22-A104-B, J-STD-003A). Another type of composite build-up materials used for embedding of circuitry are reinforced resin coated foils (RRCF) which have a glass fabric embedded within the b-staged resin. This type of composite build-up materials has the advantage of a considerable lower coefficient of thermal expansion (CTE) and a higher dimensional stability compared to RCF build-up materials. The increased dimensional stability facilitates the handling during layup and improves the reliability of the finished HDI board or IC substrate. On the other hand it is more difficult to create features such as microvias, trenches and pads through the glass fabric which significantly increases production times and therefore cost.

A third type of build-up materials suitable for embedding circuitry are prepregs which are pressed on top of the innerlayers together with copper foils on top of the prepreg. The handling of the sensitive prepregs is problematic, because the brittle prepreg material can chip away at the edges, for example during transport. Furthermore, laser drilling of microvias and through holes is constrained due to the embedded reinforcement. Another general disadvantage of prepreg materials is their VOC (volatile organic compounds) content because of the manufacturing process of the substrate materials which comprises one or more solvent-based wet chemical coating steps. Furthermore, laser drilling of microvias and through holes as well as formation of trenches by laser ablation is more difficult due to the reinforcement embedded in prepreg materials.

In general the structuring of reinforced materials with laser is difficult. This is especially true when not only micro vias are to be laser-drilled but when trenches are to be ablated by laser. The throughput is then not very high. Furthermore, light from a laser is reflected in a uncontrolled way by the reinforcement especially in case of the commonly used reinforcements made of glass. This leads to an incomplete removal of build-up material. The density of reinforcement in a resin layer is not homogeneous on a microscopic scale. This leads to a non-uniform ablation by laser light, too.

### Object of the Invention

It is, therefore, an objective of the present invention to provide composite build-up materials for embedding of circuitry which avoid the disadvantages of RCF, RRCF and prepreg material currently used for embedding of circuitry. The objects of the present invention are to provide composite build-up materials having a low VOC content and a high dimensional stability. Furthermore, such composite build-up materials should be obtained by a manufacturing process with reduced process steps. In addition, the build-up material should not be brittle and easy to handle during manufacturing and in successive manufacturing steps. Vias and the like should be easily obtained by laser drilling and trenches by laser ablation.

### Summary of the Invention

These objectives are solved with composite build-up materials having a layer sequence in the following order
(i) a carrier layer having a thickness of 1 to 200 µm
(ii) a resin layer without reinforcement having a thickness of 1 to 150 µm and
(iii) a resin layer with reinforcement having a thickness of 1 to 200 µm.

The resin layer without reinforcement is suitable for fine patterns formed by laser ablation techniques and is capable to host embedded circuitry and provide sufficient mechanical stability. Furthermore, manufacturing of printed circuit boards, IC substrates, chip packages with embedded circuitry using the inventive composite build-up materials needs less production steps when using the composite build-up materials. The composite build-up material has a high dimensional stability and has a low VOC content.

### Brief Description of the Figures

Figure 1 shows a composite build-up material according to the present invention suitable for embedding circuitry.
Figure 2 shows a composite build-up material according to the present invention with an embedded circuitry.
Figure 3 shows a composite build-up material according to the present invention suitable for embedding circuitry containing an optional release layer.
Figure 4 shows a composite build-up material according to the present invention suitable for embedding circuitry containing an optional primer layer.
Figure 5 shows a composite build-up material according to the present invention containing an optional second resin layer without reinforcement.
Figure 6 shows a composite build-up material according to the present invention containing an optional release layer and an optional second resin layer without reinforcement.
Figure 7 shows a composite build-up material according to the present invention containing an optional primer layer and an optional second resin layer without reinforcement.
Figure 8 shows a cross-section micrograph of a composite build-up material consisting of a carrier layer, a resin layer without reinforcement for embedding of circuitry, a resin layer with reinforcement and a copper clad laminate layer.
   1 carrier layer
   2 first resin layer without reinforcement
   3 resin layer with reinforcement
   4 release layer
   5 primer layer
   6 reinforcement
   7 second resin layer without reinforcement
   8 copper clad laminate
   9 embedded circuitry

### Detailed Description of the Invention

The composite build-up material according to the present invention has a layer sequence of the following order:
(i) a carrier layer (1) having a thickness of 1 to 200 µm
(ii) a resin layer without reinforcement (2) having a thickness of 1 to 150 µm and
(iii) a resin layer with reinforcement (3) having a thickness of 1 to 200 µm.

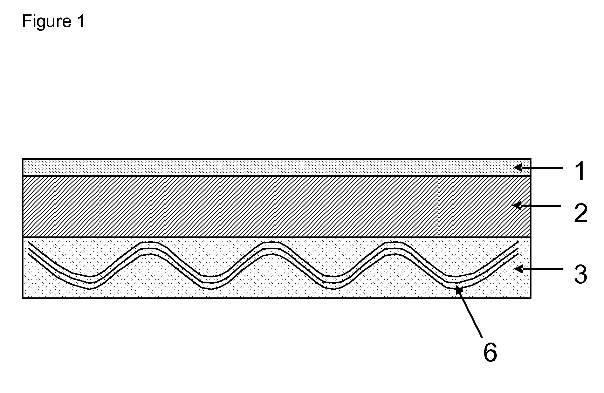

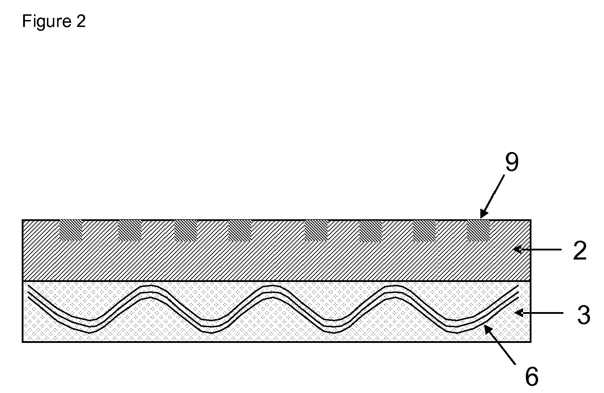

The carrier layer (1) consists, for example, of a copper foil on which a first resin layer without a reinforcement (2) is attached. The next layer consists of a resin layer with reinforcement (3). This is illustrated in Fig. 1. Said composite build-up material is useful for the embedding of circuitry (9) such as copper tracks (Fig. 2). For that purpose the composite build-up material is subjected to a laser ablating technique whereupon tracks inside the first resin layer without a reinforcement (2) are generated and subsequently filled with copper by e.g., electroplating.

A method of manufacturing an embedded circuit is disclosed in EP 1 709 849 B1 which is incorporated herein by reference. Said method comprises the steps of producing embedded features such as trenches in a dielectric layer by laser ablation and vias by laser drilling, respectively, providing a conductive coating on the surface of the embedded features, filling the embedded features with copper by electroplating and planarizing the substrate surface.

The chemical nature of the resins for the first resin layer without reinforcement (2) and the resin layer with reinforcement (3) used can be the same or different for the different layers (2) and (3). It is possible to adjust the formulation for each of the layers (2) and (3) according to the desired property profile. It is for example possible to adjust the resin formulation of layer (2) to have an extremely low modulus so that it can act as a strain buffer. The resin used in the resin layer (2) can for example be optimized in its composition to achieve optimum laser ablation properties. Also fillers can be added to layer (2) in order to reduce the CTE even more or to increase the heat conductivity. The resin used in the resin layer with reinforcement (3) can for example be optimized for optimum wetting of the reinforcement fabric. This can be achieved by using a resin formulation having an extremely low melt viscosity.

Suitable materials for carrier layer (1) are metals such as copper, aluminium, tin, paper, polymer foils made of polymers selected from the group consisting of polyethylene therephthalate (PET), polyethylene naphthalate (PEN), polyimide, polyether ether ketone (PEEK), cyclic olefin copolymer (COC), polyamide, polytetrafluoroethylene (PTFE), fluorinated ethylene propylene (FEP), ethylene tetrafluoroethylene (ETFE), THV (co-polymer of tetrafluoroethylene, hexafluoropropylene and vinylidene fluoride), polychlorotrifluoroethylene (PCTFE), polyvinylfluoride (PVF), polyvinylidene fluoride (PVDF), perfluoro alkoxy (PFA), MFA (co-polymer of tetrafluoroethylene and per-fluoro vinylether), polyarylate, ECTF ethylene-chlorotrifluoroethylene (ECTFE), polyethersulfone (PES), polymethylpentene (PMP), polyetherimide, polysulfone, and crosslinked polymer foils such as X-HDPE.

The carrier layer consists preferably of a material which can withstand the temperatures in the range of 150-250 °C which are applied during the pressing step. Said temperature depends on the resin type used.

The carrier layer (1) is more preferably selected from the group consisting of copper foil, aluminium foil, polyethylene naphthalate (PEN) foil, cyclic olefin copolymer (COC) foil and polyarylate foil.

The thickness of the said carrier layer (1), most preferably a copper foil, ranges from 1 µm to 200 µm, more preferably from 2 µm to 150 µm and most preferably from 5 µm to 100 µm.

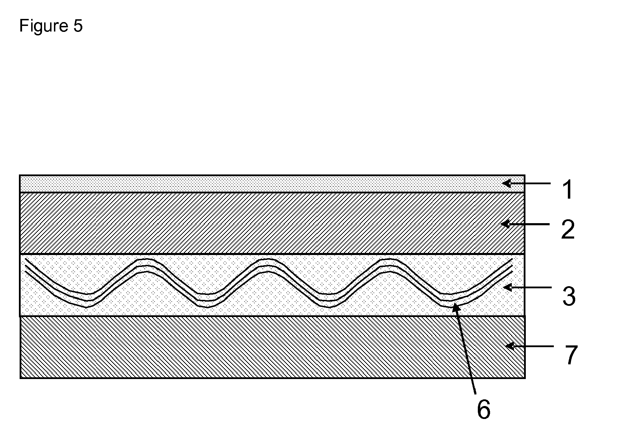

The composite build-up material according to the present invention contains a resin layer without reinforcement (2) on top of the carrier layer (1). A resin layer with reinforcement (3) is attached to the resin layer without reinforcement (2) (Fig. 1). Optionally, a second resin layer without reinforcement (7) is attached to the resin layer with a reinforcement (3) (Fig. 5).

Resin materials suitable for use in the resin layer without reinforcement (2), the resin layer with a reinforcement (3) and the optional second resin layer without reinforcement (7) are independently selected from the group consisting of epoxy resins, cyanate ester resins, bismaleimide resins, bismaleide triazine resins, benzoxazine resins, and mixtures thereof.

Epoxy resins suitable as resin material of the resin layer without reinforcement (2), resin material of the resin layer with reinforcement (3) and optional second resin layer without reinforcement (7) are independently selected from the group consisting of bisphenol-A-based epoxy resins, bisphenol-F-based epoxy resins, epoxy resins based on 3,3',5,5'-tetrabromobisphenol-A, phenolic novolac epoxy resins, novolac-modified bisphenol A epoxy resins such as D.E.R.6508 available from Dow Chemicals, cresol novolac epoxy resins, phosphorous-modified epoxy resins, diacid-modified epoxy resins, epoxysilane modified epoxy resins such a KSR-900 from Kukdo Chemicals, multifunctional epoxy resins such as 2,2',2",2"'-[1,2-ethanediylidenetetrakis(4,1-phenyleneoxymethylene)] tetrakis oxirane (CAS-no. 7328-97-4), the glycidylether of the polymer of phenol with 3a,4,7,7a-tetrahydro-4,7-methano-1H-indene (CAS-no. 119345-05-0), 4,4'-bis(2,3-epoxypropoxy)-3,3',5,5'-tetramethylbiphenyl (CAS-no. 85954-11-6), bis(2,3-epoxypropoxy)-biphenyl, trisglycidylisocyanurate, Epiclon HP-4032, Epiclon HP-820, Epiclon HP-4700, Epiclon HP-4770, Epiclon EXA 1514, Epiclon EXA 4816, Epiclon EXA 4822 resins available from DIC Europe GmbH, isocyanate-modified epoxy resins such as AER 4152, AER 5100, XAC 4151, available from Asahi Kasei Co., glycidyl esters of multifunctional aromatic carboxylic acids such as trimellitic acid and terephthalic acid, rubber-modified epoxy resins such as the reaction products of carboxy-terminated polybutabdiene and carboxy-terminated polybutadiene-acrylonitrile copolymers with bisphenol A epoxy resin and bisphenol F epoxy resins and mixtures of the aforementioned.

Preferred resin materials for the resin layer without reinforcement (2), the resin layer with reinforcement (3) and the optional second resin layer without reinforcement (7) are independently selected from formulations containing epoxy resins and epoxy resin blend formulations comprising one or more of bisphenol-A-based epoxy resins, epoxy resins based on 3,3'5,5'-tetrabromobisphenol-A, phenolic novolac epoxy resins, novolac-modified bisphenol A epoxy resins such as D.E.R.6508, cresol novolac epoxy resins, epoxy resins modified by reaction with 9,10-dihydro-9-oxa-10-phosphaphenanthrene-10-oxide, KSR-900, multifunctional epoxy resins such as 2,2',2",2"'-[1,2-ethanediylidenetetrakis(4,1-phenyleneoxymethylene)] tetrakis oxirane, the glycidylether of the polymer of phenol with 3a,4,7,7a-tetrahydro-4,7-methano-1 H-indene, 4,4'-bis(2,3-epoxypropoxy)-3,3',5,5'-tetramethylbiphenyl, bis(2,3-epoxypropoxy)-biphenyl, Epiclon HP-4032, Epiclon HP-4700, Epiclon HP-4770, Epiclon EXA 1514, isocyanate-modified epoxy resins such as AER 4152, AER 5100, XAC 4151, rubber-modified epoxy resins such as the reaction products of carboxy-terminated polybutabdiene and carboxy-terminated polybutadiene-acrylonitrile copolymers with bisphenol A epoxy resin and bisphenol F epoxy resins, cyanate ester resins, bismaleimide resins, bismaleimide triazine resins (BT), benzoxazine resins and mixtures thereof.

Most preferred resin material for the resin layer without reinforcement (2), the resin layer with reinforcement (3) and the optional second resin layer without reinforcement (7) are independently selected from formulations containing epoxy resins and epoxy resin blend formulations comprising one or more of phenolic novolac epoxy resins, novolac-modified bisphenol A epoxy resins such as D.E.R.6508, cresol novolac epoxy resins, epoxy resins modified by reaction with 9,10-dihydro-9-oxa-10-phosphaphenanthrene-10-oxide, multifunctional epoxy resins such as 2,2',2",2"'-[1,2-ethanediylidene tetrakis-(4,1-phenyleneoxymethylene)], tetrakis-oxirane, the glycidylether of the polymer of phenol with 3a,4,7,7a-tetrahydro-4,7-methano-1H-indene, Epiclon HP-4032, Epiclon HP-4700, Epiclon EXA 1514, isocyanate-modified epoxy resins such as AER 4152, AER 5100, XAC 4151, rubber-modified epoxy resins such as the reaction products of carboxy-terminated polybutabdiene and carboxy-terminated polybutadiene-acrylonitrile copolymers with bisphenol A epoxy resin, cyanate ester resins, bismaleimide resins, bismaleimide triazine resins (BT), benzoxazine resins and mixtures thereof.

Epoxy resins usually contain at least one hardener which reacts with the epoxy resin component to form a polyepoxide polymer. Suitable hardeners for use with epoxy resins in the resin layer without reinforcement (2), the resin layer with reinforcement (3) and the optional second resin layer without reinforcement (7) are independently selected from the group consisting of amines, cycloaliphatic amines, C₁-C₆- alkylated 4,4'-methylene-bis-anilines, C₁-C₆ alkylaryldiamines, anhydrides, multifunctional carboxylic acids, carboxy-functional polymers, isocyanates, blocked isocyanates, cyanate esters and multifunctional phenolic compounds, novolac resins, alkylphenol-formaldehyde novolac resins, borontrifluoride-amine adducts, epoxide-amine adducts and mixtures thereof.

In a preferred embodiment the resins in the resin layer without reinforcement (2) and the resin layer with reinforcement (3) are epoxy resins and the hardeners for use with epoxy resins in the resin layer without reinforcement (2), the resin layer with a reinforcement (3) and the optional second layer without reinforcement (7) are independently selected from the group consisting of dicyandiamide, substituted dicyandiamide, phenol-formaldehyde novolac resins, cresolformaldehyde novolac resins, triazine-substituted phenol-formaldehyde novolac resins, such as the Phenolite ATN series of compounds available from DIC Corp., tris-phenol novolacs (available as Resicure 3500, CAS-no. 225241-86-1), 3,3'-diaminodiphenyl sulphone, 4,4'-diaminodiphenyl sulphone, 4,4'-methylene-bis-(2,6-diethylaniline), dialkylaryldiamines, nadic methyl anhydride, phthalic anhydride, methyl phthalic anhydride, cyanate esters, ortho-toluylbiguanide and mixtures thereof.

Most preferred hardeners for use with epoxy resins in the resin layer without reinforcement (2), the resin layer with reinforcement (3) and the optional second resin layer without reinforcement (7) are independently selected from the group consisting of dicyandiamide, phenol-formaldehyde novolac resins, cresolformaldehyde novolac resins, triazine-substituted phenol-formaldehyde novolac resins such as the Phenolite ATN series of compounds available from DIC Corp., tris-phenol novolacs, cyanate esters, orthotoluylbiguanide and mixtures thereof.

The amount of hardener used with the epoxy resin in the resin layer without reinforcement (2), the resin layer with a reinforcement (3) and the optional second resin layer without reinforcement (7) is determined independently largely of the equivalent weights of the total epoxides and the equivalent weight of the total hardeners, with the ratio of the equivalents of epoxide:hardener independently for the epoxy resin in the resin layer without reinforcement (2), the resin layer with reinforcement (3) and optional second resin layer without reinforcement (7) selected in a range from preferably 0.5:1 to 1:0.5, more preferably from 0.7:1 to 1:0.7 and most preferably from 1:1 to 1:0.75.

The resin of the resin layer without reinforcement (2), the resin of the resin layer with reinforcement (3) and optional second resin layer without reinforcement (7) are most preferably epoxy resins and the hardener in the resin of the resin layer without reinforcement (2), the resin of the resin layer with reinforcement (3) and optional second resin layer without reinforcement (7) are independently selected from the group consisting of phenolic resins, dicyandiamide, derivatives of dicyandiamide, 4,4'-diaminophenylsulphone and mixtures thereof.

A catalyst initiates the reaction of epoxy resins used in the resin layer without reinforcement (2), the resin layer with a reinforcement (3) and the optional second resin layer without reinforcement (7) with hardeners such as the above described. Useful are catalysts that have a good thermal latency as this enables thorough mixing and blending of the reactive components of the resin layer, coating and levelling of the formulation to be carried out without triggering the crosslinking reaction prematurely. Such latent catalysts include, without being restricted to triphenyl phosphine, tetraphenylphosphonium tetraphenylborate, triphenylphosphine-1,4-benzoquinone adduct, the combination of aliphatic amines, aromatic amines and imidazoles with weak acids such as cyanuric acid, lactic acid, C₁-C₁₂ carboxylic acids, maleic acid, terephthalic acid, citric acid, boric acid, phenyl boronic acid, benzoic acid, trimellitic acid, tartaric acid and the like. The imidazoles for use both with or without weak acids can be unsubstituted or substituted in the 1-position by C₁-C₁₈ alkyl, C₆-C₁₀ aryl and benzyl, cyanoethyl, -(CH₂)ₙ-CO₂-(C₁-C₁₂ alkyl), (2,4-diaminotriazinyl-1-)-ethyl, and can be: unsubstituted or substituted in the 2-position by C₁-C₁₈ alkyl, C₆-C₁₀ aryl, benzyl, additionally the substituents at the 1 and 2 positions can together form a 5 or 6-membered fused ring and can independently of one another be: unsubstituted or substituted at the 3 and 4 positions by C₁-C₁₈ alkyl, hydroxyl, C₁-C₁₂ alkoxy, hydroxymethyl, hydroxyethyl, C₁-C₁₂ alkylcarboxyalkyl, additionally the substituents at the 3 and 4 positions can together form a fused benzene ring or fused 5 or 6-membered cycloalkyl ring. Other latent catalysts for use in epoxy resin systems independently constituting the resin of layer (2), the resin of layer (3) and the resin of optional second resin layer without reinforcement (7) include the urone latent catalysts, epoxy-amine adducts and urea derivatives such as the Omicure U series and Omicure B series of products available from CVC Specialty Chemicals.

Preferred latent catalysts for use with epoxy resin systems in resin layer without reinforcement (2), resin layer with reinforcement (3) and optional second resin layer without reinforcement (7) are selected independently from the group consisting of 6-[2-(2-methyl-1H-imidazol-1-yl)ethyl]-1,3,5-triazine-2,4-diamine optionally complexed with 1,3,5-triazine-2,4,6(1H, 3H, 5H)-trione and optionally containing one molecule of water of crystallization available from Shikoku Chemicals under the name Curezol 2MA-OK, urone catalysts such as Dyhard UR 200, Dyhard UR 300, Dyhard UR 500, the substituted ureas such as Dyhard URAcc 13 and Dyhard URAcc 43, from Evonik Corp., amine adducts with epoxy compounds such as Ajicure PN-23, Ajicure PN-H, Ajicure PN-31, Ajicure PN 40, Ajicure MY-24, Ajicure MY-23, Ajicure MY-H, Amine-epoxy adduct complexes such as Ajicure AH-203, Ajicure AH-300, DICY complexes such as Ajicure AH-154, Ajicure AH-162 and dihydrazide compounds such as Ajicure VDH from the Ajinomoto Co. and mixtures thereof.

Most preferred catalysts for epoxy systems in resin layer without reinforcement (2), resin layer with reinforcement (3) and optional second resin layer without reinforcement (7) with good latency are selected independently from the group consisting of Curezol 2MA-OK, Ajicure PN-23, Ajicure MY-24, Dyhard URAcc43, imidazole substituted in the 1-position by H, C₁ - C_{1 8} alkyl, cyanoethyl, substituted in the 2-position by H, methyl, phenyl, substituted at the 3 and 4 positions by H, methyl, hydroxyl, -CH₂OH, additionally the substituents at the 3 and 4 positions can together form a fused benzene ring and optionally complexed with C₁-C₆ carboxylic acids, terephthalic acid, boric acid, phenyl boronic acid, benzoic acid, trimellitic acid and mixtures thereof.

Such catalyst as described above are used in concentrations in the range 0.01-20 wt.-%, preferably 0.02-5 wt.-% and most preferably 0.02-1 wt.-%. When cyanate esters are used in the resin layer without reinforcement (2), resin layer with reinforcement (3) and optional second resin layer without reinforcement (7), the use of a metal catalyst is preferable. Suitable catalysts include the metal salts of Cu(I), Co(II), Fe(II) and Mn(II) with organic acids, which may for convenience be dissolved in non-volatile solvents, such as nonylphenol.

The preferred concentration of such metal catalysts is 5-500 ppm, preferably 20-100 ppm and most preferably 30-60 ppm of metal ion with respect to the total resin content without taking the optional filler into account.

Additionally the resin layer without reinforcement (2), the resin layer with reinforcement (3) and the optional second resin layer without reinforcement (7) may contain independently one or more antioxidants, flame retardants, wetting agents, optical brighteners, adhesion promoters, surfactants, leveling agents, pigments, dyes, non-reactive polymers, elastomers, tougheners, impact modifiers, ion-capturing agents, degassing agents, disperants, metal complex catalysts and rheology agents.

Flame retardants include but are not restricted to one or more of melamine derivatives, phosphorus compounds, borates, magnesium hydroxide, aluminium hydroxide, antimony trioxide, antimony pentoxide, phosphorus esters, tetrabromobisphenol, 9,10-dihydro-9-oxa-10-phosphaphenanthrene-10-oxide, bisphenol A-bis (diphenyl phosphate), alkyl-, chloroalkyl- and aryl- esters of phosphoric acid, melamine phosphate, melamine cyanurate, poly(m-phenylene methylphosphonate), ammonium polyphosphate, masterbatches of red phosphorous in an organic polymer or resin, 10-(2,5-dihydroxyphenyl)-10H-9-oxa-10-phospha-phenantbrene-10-oxide (CAS-no. 99208-50-1).

Preferred flame retardants are melamine derivatives, phosphorus compounds, tetrabromobisphenol, 9,10-dihydro-9-oxa-10-phosphaphenanthrene-10-oxide, melamine cyanurate, poly(m-phenylene methylphosphonate), ammonium polyphosphate, and 10-(2,5-dihydroxyphenyl)-10H-9-oxa-10-phospha-phenantbrene-10-oxide.

The reinforcement (6) of the resin layer with reinforcement (3) is selected from the group comprising woven and non-woven fabrics of materials selected from the group consisting of silica glass, silica glass containing metal oxides of group 1 metals, silica glass containing metal oxides of group 2 metals, silica glass containing metal oxides of group 1 and group 2 metals, E-glass, alumino silicates, silicon nitride, boron nitride, Wollastonite, ceramic oxides, aramides such as Kevlar^{®} and mixtures thereof.

Preferably, the reinforcement (6) consists of aramide fiber or E glass, the composition range of which is described in section 3.1.6 of the IPC document 4412 (May 2002 version).

The surface of the reinforcement (6) is preferably modified with silane adhesion promoters, most preferably with epoxy silanes and amino silanes.

Examples of suitable woven glass styles include but are not restricted to those listed in the IPC-4412A Amendment 1 (March 2008 version) and the glass style 7630, 1074, 1013, 0809, 1555, 1010.

Preferred glass fabric styles are 1015, 1017, 1027, 106, 1080, and 1037.

Examples of suitable non-woven glass fabrics include but are not restricted to glass fiber tissue such as AG H 35, AG H 55, AG H 70, AG H 75, AG H 100, AG H 105 and the like which are available from Saint-Gobain Vetrotex International S.A. and flat glass fiber sheet available from Nitto Boseki Co. Ltd.

Example of suitable organic fibers include but are not restricted to non-woven Aramid reinforcement such as type 2.0N710, 3.0N710 and 4.0N710 from Du-Pont.

The thickness of the cured resin layer without reinforcement (2) ranges from 1 µm to 150 µm, more preferably from 5 µm to 100 µm and most preferably from 10 µm to 50 µm.

The thickness of the cured resin layer with reinforcement (3) ranges from 1 µm to 200 µm, more preferably from 5 µm to 150 µm and most preferably from 10 µm to 100 µm.

The thickness of the cured optional resin layer without reinforcement (7) ranges from 5 µm to 500 µm, more preferably from 10 µm to 300 µm and most preferably from 20 µm to 200 µm. Optionally, the resin of resin layer without reinforcement (2), the resin of resin layer with a reinforcement (3) and the optional second resin layer without reinforcement (7) contain independently from each other filler particles such as aluminium oxide, fused silica, fumed silica, boron nitride, barium sulfate, calcium carbonate, aluminium hydroxide, antimony pentoxide, antimony trioxide, apatite, carbon black, attapulgite, barium titanate, bentonite, beryllium oxide, calcium sulfate, clay, cristobalite, dolomite, feldspar, metal oxides, kaolin, magnesium oxide and the like.

Said filler particles are utilized in one embodiment of the present invention to reduce the CTE of the resin layer without reinforcement (2) and/or of the resin layer with a reinforcement (3) and/or the optional resin layer without reinforcement (7) even more or increase the heat conductivity of the resin layer without reinforcement (2) and/or the resin layer with reinforcement (3) and/or the optional second resin layer without reinforcement (7).

The most preferred filler particles for the resin layer without reinforcement (2), the resin layer with reinforcement (3) and the optional second resin layer without reinforcement (7) are independently selected from the group consisting of aluminium oxide, fused silica, fumed silica and boron nitride.

The use of optional fillers for both the resin layer without reinforcement (2), the resin layer with reinforcement (3) and the optional second resin layer without reinforcement (7) having spherical shape or having an aspect ratio in the range of 1:1-1:1.5 is most preferred.

In order to improve the cohesive strength of the resin layer without reinforcement (2) and/or of the resin layer with reinforcement (3) and/or the optional resin layer without reinforcement (7) and to improve the water impermeability of said layers it is preferred to modify the surface of the optional fillers using organic alkoxysilanes, epoxysilanes, aminosilanes, mercaptosilanes, acetoxysilanes and azasilanes. In the case of the alkoxysilanes and acteoxysilanes, these hydrolyse in the presence of moisture to form the corresponding reactive silanols, which then condense with hydroxyl groups on the surface of the fillers with the liberation of water. The fillers can be either pretreated with silanes or the silane added to the mixture during mixing or processing. A comprehensive treatise on the methods of surface modification of fillers using silanes and azasilanes can be found in the Internet publication "Silane Coupling Agents: Connecting across Boundaries" by Barry Arkles on the website www.gelest.com.

If a solvent-free coating method for the application of the resin layer without reinforcement (2) and/or resin layer with reinforcement (3) and/or optional resin layer without reinforcement (7) is used, it is preferred to either use an already-surface-treated filler or to carry out the addition of the surface modification agent in the extrusion blending step. Suitable surface modification agents include but are not restricted to one or more epoxy silanes such as 2-(3,4-epoxycyclohexyl)ethyltriethoxy silane, 2-(3,4-epoxycyclohexyl)ethyltrimethoxysilane, (3-glycidoxypropyl)trimethoxysilane, (3-glycidoxypropyl)triethoxysilane, 5,6-epoxyhexyltriethoxysilane, (3-glycidoxypropyl)methyldiethoxysilane, (3-glycidoxypropyl)methyldimethoxy-silane, (3-glycidoxypropyl)dimethylethoxysilane, aminosilanes such as 3-aminopropyltriethoxysilane, 3-aminopropyl-trimethoxysilane, aminophenyl-trimethoxysilane, 3-aminopropylmethyldiethoxysilane, 3-aminodimethyl-ethoxysilane, N-(2-aminoethyl)-3-aminopropyltrimethoxysilane, N-(2-aminoethyl)-3-aminopropyltriethoxysilane, (3-trimethoxy-silylpropyldiethylene-triamine, n-butylaminopropyltrimethoxysilane, N-ethylamino-isobutyltrimethoxysilane, N-ethylaminopropyltrimethoxysilane, (N,N-diethyl-3-aminopropyltrimethoxysilane, bis(3-trimethoxysilylpropyl)amine, bis[(3-trimethoxysilyl)propyl]-ethylenediamine, 3-mercaptopropyltrimethoxysilane, 3-mercaptopropylmethyldimethoxysilane, hexadecyltrimethoxysilane, octyl-trimethoxysilane, isobutyltrimethoxysilane, phenyltrimethoxysilane, bis(triethoxysilyl)ethane, tris(3-trimethoxysilylpropyl)isocyanurate, bis[3-(triethoxysilyl)propyl]urea, (3-acryloxypropyl)trimethoxysilane, methacryloxypropyltrimethoxysilane, n-butyltrimethoxysilane, hexamethyldisilazane, N-n-butyl-aza-2,2-dimethoxysilacyclopentane, 1,3-divinyltetramethyldisilazane, vinyldi-methylethoxysilane, styrylethyltrimethoxysilane, vinyltrimethoxysilane.

The optimum amount of silane, azasilane or silanol added to the filler is a quantity sufficient to form a monolayer on the surface of the filler and that has reacted with all of the surface hydroxyl groups of the filler. This quantity is typically in the range 0.01-5 wt.-% with respect to the filler, preferably 0.05-2 wt.-% and most preferably 0.1-1.5 wt.-%.

In addition to the already mentioned filler particles, the resin layer without reinforcement (2) can contain other functional filler particles which can serve as a conductive seed for the subsequent deposition of copper into the embedded structures. These structures are formed by laser ablation, on ablation the resin is partially removed, the metal particles appear on the surface, metal is deposited in an electroless step, and the trenches are filled either in a fully electroless process or by galvanic plating.

The preferred filler particles for that purpose are iron, copper, aluminium, nickel, inorganic compounds of these metals with oxygen, nitrogen, and sulfur.

The metal and metal alloy particles suitable as functional filler particles in the resin layer without reinforcement (2) have a size (diameter) which ranges from 0.1 µm to 40 µm, more preferred 0.2 µm to 20 µm, and most preferred from 0.3 µm to 5 µm.

In still another embodiment of the present invention the resin layer without reinforcement (2) contains a component which absorbs strongly at the wavelength of the laser which is used for the ablating process to create the embedded tracks such as microvias, trenches and pads which later form the embedded circuitry. Such dyes are for example HABI-221, HABI-1311, HABI-1311 A, (all available from DSK), dyes from the Irgalite series (available from Ciba Specialty Chemicals), dyes from the Chromophtal series (available from Ciba Specialty Chemicals), dyes from the Irgacure series (available from Ciba Specialty Chemicals), dyes from the Darocur series (available from Ciba Specialty Chemicals) which are added to the resin formulation. The concentration of "the compounds" in the resin formulation range from 0.01 to 5 %, more preferably from 0.02 to 4 %, and most preferably 0.03 to 3 %.

In one embodiment of the present invention the resin materials used for the resin layer without reinforcement (2) and the resin layer with reinforcement (3) are the same.

In still another embodiment of the present invention the resin materials used for the resin layer without reinforcement (2), the resin layer with reinforcement (3) and the optional resin layer without reinforcement (7) are the same.

In still another embodiment of the present invention the composite build-up material contains an optional second resin layer without reinforcement (7) on top of the resin layer with reinforcement (3) (Fig. 5). Said optional layer (7) enables embedding of active components such as micro chips into the composite build-up material while maintaining the advantages for embedding of circuitry. For that purpose the composite build-up material is pressed on the chip with the optional resin layer without reinforcement (7) facing the active component, e.g., the micro chip. Active components are electronic components activated by an external source of power. Active components are for example micro-chips, transistors, diodes and other integrated circuits.

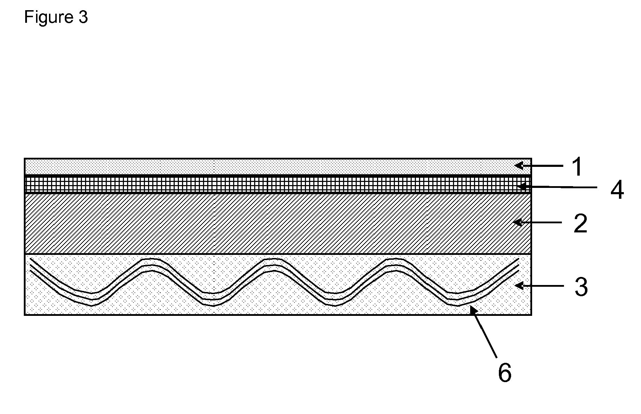

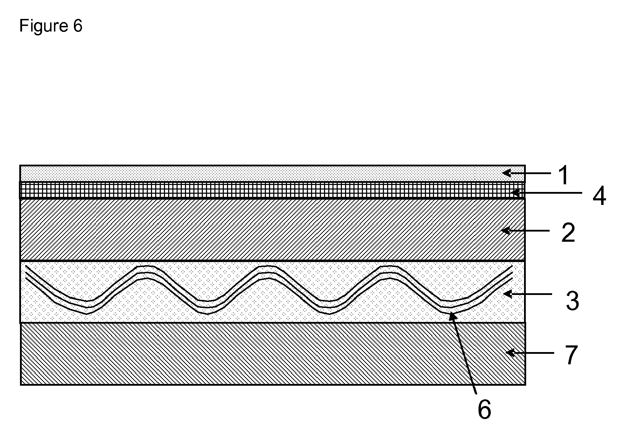

In one embodiment of the present invention as shown in Fig. 3 and Fig. 6 the composite build-up material suitable for embedding circuitry has a layer sequence in the following order:
(i) a carrier layer (1) having a thickness of 1 to 200 µm
(ii) b) a release layer (4)
(ii) a resin layer without reinforcement (2) having a thickness of 1 to 150 µm and
(iii) a resin layer with reinforcement (3) having a thickness of 1 to 200 µm.

A release layer (4) is deposited onto carrier layer (1) that enables easy detachment of the carrier layer (1) together with the release layer (4) from the resin layer without reinforcement (2) before formation of, vias by laser drilling and-trenches by laser ablation for embedding of circuitry (Figs. 3 and 6). This easy release is especially useful when the carrier layer (1) itself has no function in the final electronic assembly other than providing mechanical stability during manufacture of the composite build-up material. In that case the carrier layer (1) can easily be peeled off from the substrate after press-curing.

In the semi additive process (SAP) for manufacture of printed circuit boards, IC substrates and the like the carrier layer (1) is not required for forming conductive tracks. Instead, the carrier layer (1) can be fully removed first by etching in an acidic bath (if metal) or by peeling-off. Thereafter in both cases, a very thin layer of electroless copper is deposited onto the surface of the resin layer without reinforcement (2), a resist is then applied on the thin copper layer, the resist is developed, the open copper is then electrolytically built up, the resist is stripped, and a flash-etch step removes the thin copper layer from the beginning at the positions where no galvanic copper was deposited. In this case, the carrier layer (1) is only needed for the transfer of the resin layers (2) and (3) to the electronic assembly before pressing the electronic assembly.

Suitable release layers (4) are selected from the group consisting of silicones such as polydimethylsiloxane (PDMS), hydrocarbon oils, waxes, crosslinked silicone polymers, crosslinked polymers based on acrylates and vinyl monomers, vinyl polymers, cured epoxy resins, polyurethanes, polyamides, polyesters, polyolefins, sol-gel coatings based on silanes and silazanes, fluorinated polymers such as polytertafluoro ethylene (PTFE), and molecular materials such as heterocyclic compounds containing at least one thiol group, e.g., 1 H-1,2,4-triazole-3-thiol (1,2,4-triazole-3-thiol, 3-mercaptotriazole, CAS No. 3179-31-5), 3-amino-1,2,4-triazole-5-thiol (3-amino-5-mercapto-1,2,4-triazole, CAS No. 16691-43-3), 2-mercaptobenzothiazole and 2-mercaptobenzimidazole. Said release layer (4) forming heterocyclic compounds containing at least one thiol group are used for deposition onto the carrier layer (1). For said purpose, such compounds are dissolved in a suitable solvent such as water in a concentration in the range of 1 mg/l to 1000 mg/l. Most preferred release layers (4) are sol-gel coatings based on silanes, crosslinked silicone polymers, crosslinked polymers based on acrylates and vinyl monomers.

In another embodiment of the present invention the composite build-up material suitable for embedding of circuitry has a layer sequence in the following order:
(i) a carrier layer (1) having a thickness of 1 to 200 µm
(ii) b) a primer layer (5)
(ii) a resin layer without reinforcement (2) having a thickness of 1 to 150 µm and
(iii) a resin layer with reinforcement (3) having a thickness of 1 to 200 µm.

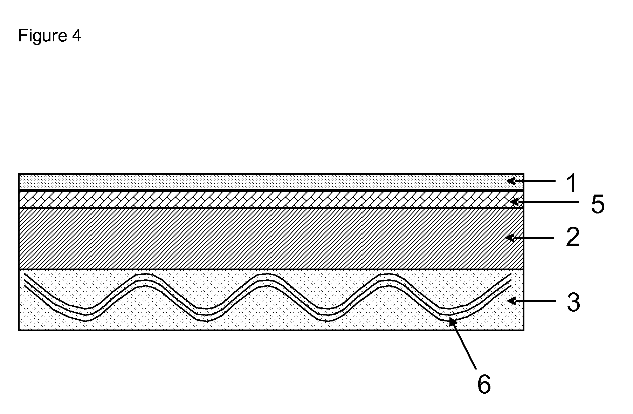

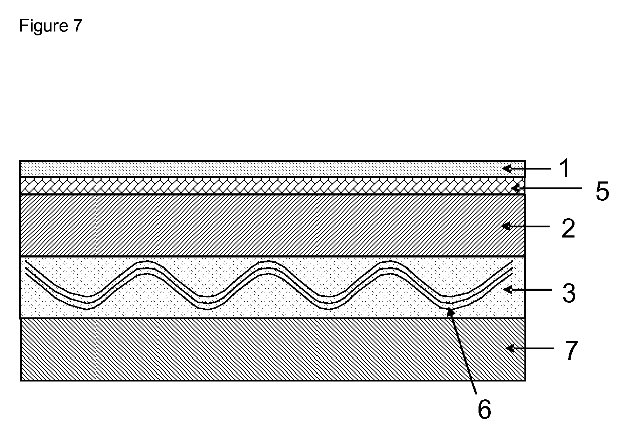

The carrier foil (1) can also be endowed with a primer layer (5) before the resin layers (2) and (3) are applied (Fig. 4 and Fig. 7). This primer layer remains adhering to the dielectric layer after press-lamination and curing. The primer layer (5) is made of a resin formulation having especially good adhesion to copper which is important when the carrier layer (1) remains part of the final assembly. The primer layer (5) consists of a resin material having a Tg value of 50-300°C, preferably 80-250°C, most preferably 130-220°C, as determined by DSC (IPC TM-650 2.4.25).

The components of said primer layer are selected from the same components used in resin layers (2) and (3) but formulated for optimum adhesion in case a copper foil is used as a carrier layer (1).

An optional primer layer (5) is preferred if the carrier layer (1) is made of a metal such as copper, aluminium and tin.

An optional primer layer (5) is also preferred if the carrier layer (1) is not removed from the build-up assembly in a later process step.

The thickness of the said primer layer (5) ranges from 1 µm to 20 µm, more preferably from 2 µm to 10 µm and most preferably from 3 µm to 5 µm.

The primer layer (5) can be applied as a powder by electrostatically spraying, by an electro magnetic brush process, powder scattering by direct melt extrusion.

In one embodiment of the present invention, the primer layer (5) is preferably coated from solution by curtain coating, slot coating, roller transfer coating, dip coating, spraying, spin coating, most preferably by curtain coating and slot coating. For the purposes of the solvent coating the use of surface active agents such as non-ionic and anionic surfactants, acrylates, fluorinated surfactants and silicones is useful. Suitable solvents for use with the primer include but are not restricted to dichloromethane, dichlorethane, acetone, methylethylketone, ethyl acetate, butyl acetate, methanol, ethanol, propanol, butanol, isobutanol, ethylene glycol, ethylene carbonate, propylene carbonate, glycerolcarbonate, N-methyl formamide, N-methylpyrollidone, N-ethylpyrollidone, benzene, toluene, xylene, cellosolves, carbitols, tetrahydrofuran, ethoxyethylproprionate, benzyl alcohol, cyclohexanone, dimethylsulphoxide, hexane, heptane, octane, nonane, petroleum ether, cyclohexane and mixtures thereof.

In one embodiment of the present invention, the primer layer (5) contains electrical conductive filler particles selected from the group consisting of metal particles and metal alloy particles. The most preferred metal and metal alloy particles are selected from the group consisting of copper, silver, palladium, chromium, iron, cobalt and nickel and alloys thereof. Said filler particles are suitable for formation of an embedded circuitry inside the primer layer (5). When forming the embedded structures such as trenches for embedding of a circuitry by laser ablation techniques said electrical conductive filler particles are exposed and can serve as a conductive seed for the subsequent deposition of copper into the embedded structures which form then the embedded circuitry inside the primer layer (5).

The metal and metal alloy particles suitable as filler particles in the primer layer (5) have a size (diameter) which ranges from 0.1 µm to 40 µm more preferred 0.2 µm to 20 µm, and most preferred from 0.3 µm to 5 µm.

The manufacturing of the composite build-up materials suitable for embedding active components is described in the following:

A carrier layer (1) (e.g., a copper foil) is coated in a first step with a resin formulation, preferably in a continuous reel-to-reel process. Said resin will later form the resin layer without reinforcement (2). The resin material is dissolved in a suitable solvent and applied in a wet coating process to the carrier layer (1), e. g., by using a comma coater, a slot coater, bar coater, curtain coater, by spraying or dip coating.

In another, and preferred embodiment the resin or resin layer without a reinforcement (2) is formulated without the use of solvents and coated by means of a solvent-free method wherein a solvent-free resin powder is deposited, the method selected from the group comprising powder spraying, electromagnetic brush process, powder scattering process and direct melt extrusion process. The most preferred deposition method for the resin layer without reinforcement (2) is deposition of a solvent-free resin powder by a method selected from the group consisting of electromagnetic brush process, powder scattering process and direct melt extrusion process.

For deposition of solvent-free resin powders, standard production equipment used commercially for the production of powder coatings is suitable for the formulation step, as described in chapter 4 of the book "Powder Coatings Chemistry and Technology" by Pieter Gillis de Lange, 2004 and published by C.H.I.P.S., Texas. The dry resins, fillers and additives are weighed out and mixed together to form a premix using a suitable mixer. Examples of suitable mixers are conical mixers, drum mixers, double-cone mixers, vertical mixers, helical screw mixers and the like. The resins, fillers and additives are then compounded in a twin-screw extruder, a single-screw cokneader, planetary extruder or other suitable equipment. The premix is then processed through the extruder at a temperature in the range of 70-220°C and preferably 70-120°C. Liquid components, if used, are directly injected into the melt in the extruder. The extruded melt is cooled by passage through cooled nip-rollers on a cooling belt or compact cooler and chipped. If the formulation contains components having a high melting point or softening point the use of a high process temperature, for example above 150°C, is advantageous. It is also preferred to process the formulation in two extruder passes with the catalysts added only in the second extruder pass and at the lowest practicable melt temperature, typically in the range of 90-120°C. This reduces the risk of a runaway crosslinking reaction taking place in the extruder. The formulation in chip form is then either further processed to a powder for application by a electromagnetic brush (EMB) process, powder scattering or direct melt extrusion.

When the carrier layer (1), optionally pre-coated with the resin layer without reinforcement (2) is coated by direct melt extrusion, it is particularly important that the melt be degassed by application of a vacuum to the melt prior to extrusion through the slit. It is equally important that the melt temperature be kept as low as possible, preferably in the range of 80-200°C, more preferably 90-150°C and most preferably 100-130°C, to prevent curing in the slit extrusion machine. It is also preferable that the formulation be made with a melt viscosity as low as possible. Suitable equipment for direct extrusion onto the carrier layer (1), optionally having a primer layer (5) and optionally already coated with the resin layer without reinforcement (2) is the ZK-D manufactured by Dr. Collin GmbH, D-85560 Ebersberg.

In one preferred embodiment of the invention, the formulation is extruded without catalyst and the catalyst added separately before the direct extrusion step, optionally in the form of a masterbatch in one of the resins, such as phenolic resin hardener.

A further embodiment of the invention is the direct melt extrusion of all the components of the formulation in one single pass. For this option an extruder with a long barrel (minimum length:bore diameter >36) is preferred. It is preferred to pass the slit-extrusion-coated substrate through a callandering roller directly after the slit extrusion. After slit extrusion the coated substrate can be passed through an oven to adjust the degree of b-staging before being cooled down and wound up.

If direct melt extrusion is used to apply the resin of the resin layer without reinforcement (2), it is possible to feed the coated substrate directly into the lamination equipment without winding up before. A particular advantage of the direct melt extrusion method of coating is that a much thicker layer can be laid down than by any other method.

If a powder scattering method is used in which a solvent-free resin powder is applied to the substrate, the extruded chips are first milled and optionally classified, preferably using a classifying mill and finally sieved to give a powder with a particle size having a size distribution peak maximum in the range 5-200 µm, preferably 10-100 µm and most preferably 30-80 µm. Other types of mill which can be used include pin mills, ultracentrifugal mills and the like. Classification of the powder is not strictly necessary, but is useful to reduce the amount of powder below 10 µm in size, which poses an inhalation hazard and to ensure that the amount of oversize particles is kept to a minimum. Milling and classification can be carried out as separate operations. Suitable sieves are gyratory sieves, vibratory sieves and ultrasonic sieves fitted with a suitable mesh in the range 60-300 µm, preferably 120-250 µm. The powder particle size distribution is determined by dry sieve analysis, sedimentation, Coulter counter or preferably by laser diffraction.

For application of a solvent-free resin powder using an electromagnetic brush, the powder is mixed with a suitable electromagnetic carrier, such as Type AT 100-01 from Büro-Communication Wagner GmbH in the ratio range 5:95 to 50:50, preferably 10:90 to 40:60 and most preferably 15:85 to 25:75 parts powder:carrier by weight and coated onto the carrier layer (1), which may be uncoated or already have been coated with the resin layer without reinforcement (2) and laminated using a laboratory electromagnetic brush apparatus scattered on a scattering line using a rotating drum studded with needles. The spaces between the needles, the rotation speed of the electromagnetic drum and the speed at which the substrate passes underneath dose the meter the amount of powder applied to the substrate. A solvent-free application method using an electromagnetic brush is disclosed for example in EP 1 807 219 A1 which is incorporated here by reference.

The coated carrier layer (1) is then passed through an oven and heat treated, preferably in a continuous reel-to-reel process. The coated resin layer without reinforcement (2) is not fully cured but the oven settings must be chosen in such a manner that the resin still forms a closed film on the surface of the carrier layer (1) but at the same time remains in a semi-cured state, forming a so-called "b-staged" material. In the case when a powdered resin is used the high oven temperature causes the powder particles to melt, degass, coalesce and flow together to form a closed film on the copper surface. After cooling and winding up the roll, the coated carrier layer (1) is ready for the second step of the production.

The extent of the b-staging or degree of conversion is best determined by differential scanning calorimetry. By heating at a constant heating rate of 20 °C/min in an atmosphere of flowing nitrogen the extent to which the reactive groups present in the formulation have reacted during b-staging can be determined and compared to the enthalpy of the non-b-staged material.

The carrier layer (1) with attached resin layer without reinforcement (2) is coated with a resin for a second time to form the resin of the resin layer with reinforcement (3), using either a solvent process or a solvent-free process as previously described for the deposition of the resin layer without reinforcement (2).

However, it was found to be of the utmost importance, that the resin layer with reinforcement (3) be applied on top of the resin layer without reinforcement (2) by a solvent-free coating method, as solvents cannot be easily removed from the material of the invention once it has diffused into resin layer without reinforcement (2). The consequence of using solvents to apply resin layer with reinforcement (3) is the formation of solvent vapour bubbles on heating. Alternatively, very mild heating conditions would have to be used to drive off the residual solvent, which would necessitate an excessively long drying zone and make the production process uneconomic.

The most preferred deposition method for the resin layer with reinforcement (3) is a solvent-free deposition selected from the group consisting of electromagnetic brush process, powder scattering and direct melt extrusion.

In the case of the resin layer with reinforcement (3), excessive heating of the coating, i.e., b-staging, results in a resin layer (3) that is unable to flow sufficiently into the reinforcement on lamination. This results in voids under the reinforcement and poor embedding. The extent of the b-staging required is therefore highly dependent on the initial viscosity of the formulation (before b-staging) and whether or not it contains a filler. In practice it has been found useful to use heating conditions sufficient to ensure a degree of conversion of 0.1-50 %, preferably 0.2-40 % and most preferably 0.3-25 % for formulations that are coated without solvents. For solvent coated formulations which may contain liquid resins, higher degrees of conversion are recommended: 1-80 %, preferably 2-60 % and most preferably 3-50 %. Ovens suitable for the b-staging process include infrared ovens, near infrared ovens, convection ovens and combinations thereof. Microwave ovens are also suitable provided that the carrier layer **1** is either non-metallic or non-conductive.

If a solvent coating operation is chosen, the temperature profile in the oven must be chosen which avoids the formation of bubble through the evaporation of solvent and which subsequently enables the resin to reach the required degree of b-staging.

The resin from the resin layer with reinforcement (3) is laminated, preferably in a reel-to-reel process, with a reinforcement, e.g., a glass fabric. This lamination operation is carried out at elevated temperature and with the application of pressure.

In one embodiment of the present invention, the coated substrate, optionally is laminated on-line, directly after b-staging and without a wind-up step. Suitable equipment for the embedding of the reinforcement are nip-roll laminators, heated calendaring rolls, heated drum-and-belt laminators, belt laminators, flat bed belt-laminators and combinations thereof. Heated presses with and without vacuum can also be used if a sheet-wise production is used instead of the preferred reel-to-reel process.

The preferred equipment for the embedding of the reinforcement into layer (3) is a flat-bed belt-laminator, most preferably the flat bed laminator is fitted with a subsequent calendaring roll.

For optimal embedding of the reinforcement into resin layer (3) it is important that a combination of heat and temperature be used. The temperature range in which a flat bed laminator should be used with the material of the invention is 50-300°C, preferably 70-200°C and most preferably 100-170°C. The pressure to be exerted on the belt is in the range of 0.05-100 N/cm², preferably 0.1-20 N/cm² and most preferably 0.3-10 N/cm². The callander roll pressure depends on the diameter of the rollers used, but should exert a pressure on the material of the invention greater than that used on the belt. The construction of the belt laminator should be such that a non-stick material such as polytetrafluoroethylene, a crosslinked silicone polymer or silicone paper is kept in contact with the composite build-up material during embedding operation. The carrier layer (1) thus coated with the resin layer without reinforcement (2) and the resin layer with reinforcement (3) is then cooled to a temperature in the range of 0-100°C, preferably 25-70°C and most preferably 30-50°C and wound up and the resulting roll is used in the next production step.

The most preferred solvent-free deposition method for deposition of the resin of the resin layer with reinforcement (3) is selected from the group consisting of deposition by means of an electromagnetic magnetic drum, powder scattering and direct melt extrusion.

After winding up the roll is cut to sheets of the required sheet size according to the customers demand.

The described manufacturing process of a composite build-up material according to the present invention is continuous in the sense that all process steps are reel-to-reel processes. The thickness of each layer can be adjusted within a wide range, according to the targeted end application. Especially noteworthy is the fact that the resin formulations for each of the layers (2) and (3) can be tuned to its individual function. Also the type of glass fabric can easily be changed, the use of very thin glass fabrics does not pose any problem with handling since it is supplied from a roll and continuously laminated in the resin layer of the build up material. The problems known in the industry with the handling and the mechanical sensitivity of very thin prepregs are entirely avoided. The manufacturing of said build-up materials uses well known and established methods and readily available equipment in order to provide materials which are urgently needed. The ongoing trend towards higher reliability, increased miniaturization, and faster production cycles in the area of chip packaging demands these types of materials.

Optionally, a second resin layer without reinforcement (7) is coated onto the resin layer with reinforcement (3) in a continuous reel to reel process as described for application of the resin layer without reinforcement (2) and the resin layer with reinforcement (3), i.e., by wet chemical or solvent free deposition processes as described above for deposition of the resin layer without reinforcement (2) and the resin layer with reinforcement (3).

Preferably, the second resin layer without reinforcement (7) is deposited by a solvent-free deposition method.

The most preferred deposition methods for the optional second resin layer without reinforcement (7) are solvent free deposition methods, selected from the group consisting of electromagnetic brush process, powder scattering and direct melt extrusion.

The coated carrier layer (1) is then continuously passed through an oven and heat treated. The coated optional resin layer without a reinforcement (7) is not fully cured but the oven settings must be chosen in such a manner that the resin still forms a closed film on the surface of the resin layer with reinforcement (3) but at the same time remains in semi-cured state, forming a so-called b-staged material.

After winding up the roll is cut to sheets of the required sheet size according to the customers demand.

The described manufacturing process is continuous in the sense that all process steps are reel to reel processes. The thickness of each layer can be adjusted within a wide range, according to the targeted end application. Furthermore, the resin formulation for each of the layers (2) and (3) and the optional layer (7) can be tuned to its individual function. Also the type of glass fabric can easily be changed, the use of very thin glass fabrics does not pose any problem with handling since it is supplied from a roll and continuously laminated in the resin layer of the build up material. The problems known in the industry with the handling and the mechanical sensitivity of very thin prepregs are entirely avoided. The manufacturing of said build-up materials uses well known and established methods and readily available equipment in order to provide materials which are urgently needed. The ongoing trend towards higher reliability, increased miniaturization, and faster production cycles in the area of printed circuit board, IC substrate and chip package manufacturing demands these types of materials.

The technical advantage when using the inventive composite build-up material for embedding of circuitry compared to build-up materials known in the art are: in order to achieve the same property profile necessary for embedding of circuitry with conventional means would result in a much longer and time consuming production process. The chip packaging for example is manufactured in known processes by laminating an RCF material.

The following examples further illustrates the present invention.

### Example

### Preparation of resin powders for layers (2) and (3)

The resin components listed in Table 1 were weighed out in the quantities shown and thoroughly mixed together in a polyethylene bag.

**Table 1: components used for the preparation of the resin powders for resin layers (2) and (3).**

| Component | Quantity (g) |
|---|---|
| Multifunctional solid epoxy resin | 480 |
| Bakelit PF 0790 K03 | 180 |
| Submicron sized silica | 338 |
| Total: | 998 |

A dicyclopentadienyl-bridged multifunctional solid epoxy resin, Bakelit PF 0790 K03 which is a phenol-formaldehyde-based, phenolic resin (CAS-no. 9003-35-4), and a submicron sized silica filler with an average particle size of 0.3 microns and a spherical particle shape, are used as raw materials. The mixed components of the dielectric were then extruded on a 19 mm-bore, 5-zone, 24 I/d, twin screw extruder made by OMC, Italy and fitted with screws having the maximum number of mixing elements. The barrel temperature in the mixing zones was set to 100°C and the rotation speed to 600 rpm, which gave a throughput of approximately 3 kg/hr and a melt temperature of 100 - 105 °C. The extruded melt was cooled by passage through water-cooled nip rollers and crushed. The finely crushed flakes were then mixed with Curezol 2MA-OK latent catalyst, in the proportion 998 g extruded flakes to 2 g Curezol 2MA-OK. The mixture containing the catalyst was then extruded a second time using the same conditions as for the first pass. The catalysed formulation was then crushed and milled using a Retsch ZM-1 Ultracentrifugal mill at 14'000 rpm and using a milling sieve, mesh size 0.25 mm. The resulting resin powder was subsequently sieved through a 160 micron sieve using a gyratory sieve made by Fuchs Maschinenbau AG, Granges Paccot, Switzerland.

*Deposition of the resin layer without reinforcement (2) onto the carrier layer (1)*

A copper foil of 18 µm thickness as carrier layer (1) (Type JTC, Gould Electronics GmbH, Eichstetten, Germany) is coated in a reel-to-reel coating line with the resin powder prepared in above using the electro magnetic brush coating technology in order to obtain the resin layer without reinforcement (2). A quantity of 6 kg of said resin powder is mixed intensively with 34 kg of magnetic carrier particles (DFC2023C, Dowa, Okayama City, Japan) for 30 minutes. This mixture is inserted to the container of the EMB machine (EMB Technology, Broek op Langedijk, The Netherlands) and kept in continuous movement using a fluidized bed. The magnetic drum speed is set to 90 m/min and the line speed to 6 m/min. The voltage is set to 400 V, and the gap between the brush drum and the copper substrate is set to 4 mm. The amount of resin powder which is transferred to the copper foil substrate is continuously replenished using a powder feeding system (DDF pump, Ramseier Technolgies, Luterbach, Switzerland). The powder coating is molten in an IR oven, the surface temperature of the coating being 190 °C. The thickness of the resulting resin layer without reinforcement (2) is 20 µm as measured by the area weight. The thickness distribution over the width and the length of the resin layer without reinforcement (2) sample is 20 µm ± 2 µm.

*Deposition of the resin for the resin layer with reinforcement (3) onto the resin layer without reinforcement (2)*

The roll of copper foil (= carrier layer (1)) with the resin layer without reinforcement (2) obtained above is coated again on the EMB machine as described in above in order to deposit the resin of resin layer with reinforcement (3). This time the bias voltage was set to 700 V and the line speed reduced to 5 m/min in order to reach a slightly higher coating thickness of 45 µm.

*Embedding of a reinforcement into the resin of the resin layer with reinforcement (3)*

The roll is then inserted into a flat belt laminator and continuously passed in a reel to reel fashion through the laminator together with a glass fabric type (Company Meyer, Germany) with a line speed of 3 m/min. The lamination temperature is 140 °C. This intermediate shows no blisters, the glass fabric is well embedded at all positions in the length and the width of the substrate and shows no wrinkles.

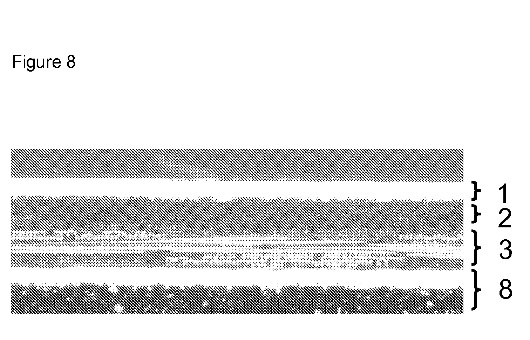

The obtained composite build-up material consisting, in this order, of a carrier layer (1), a resin layer without reinforcement (2) and a resin layer with reinforcement (3) was pressed on a copper clad laminate (8) (maximum temperature = 190 °C, maximum pressure = 20 bar). A cross section micrograph of the sample is shown in Figure 8. After removal of the carrier layer (1) by e.g., etching, the composite build-up material is suited for embedding of circuitry into the resin layer without reinforcement (2) by procedures disclosed in EP 1 709 849 B1.

## Claims

1. A composite build-up material suitable for embedding of circuitry, the composite build-up material having a layer sequence in this order of
(i) a carrier layer (1) having a thickness of 1 to 200 µm
(ii) a resin layer without reinforcement (2) having a thickness of 1 to 150 µm and
(iii) a resin layer with reinforcement (3) having a thickness of 1 to 200 µm.

2. The composite build-up material according to claim 1 wherein the carrier layer (1) is selected from the group consisting of copper, aluminium, tin, paper, polymer foils made of polymers selected from the group consisting of polyethylene therephthalate (PET), polyethylene naphthalate (PEN), polyimide, polyether ether ketone (PEEK), cyclic olefin copolymer (COC), polyamide, polytetrafluoroethylene (PTFE), fluorinated ethylene propylene (FEP), ethylene tetrafluoroethylene (ETFE), THV (co-polymer of tetrafluoroethylene, hexafluoropropylene and vinylidene fluoride), polychlorotrifluoroethylene (PCTFE), polyvinylfluoride (PVF), polyvinylidene fluoride (PVDF), perfluoro alkoxy (PFA), MFA (co-polymer of tetrafluoroethylene and per-fluoro vinylether), polyarylate, ECTF ethylene-chlorotrifluoroethylene (ECTFE), polyethersulfone (PES), polymethylpentene (PMP), polyetherimide, polysulfone, and crosslinked polymer foils such as X-HDPE..

3. The composite build-up material according to any of the foregoing claims wherein the carrier layer (1) is selected from the group consisting of copper foil, aluminium foil, polyethylene naphthalate (PEN) foil, cyclic olefin copolymer (COC) foil and polyarylate foil.

4. The composite build-up material according to any of the foregoing claims wherein the resin used for the resin layer without reinforcement (2) is selected from the group consisting of epoxy resins, cyanate ester resins, bismaleimide resins, bismaleide triazine resins, benzoxazine resins, and mixtures thereof.

5. The composite build-up material to any of the foregoing claims wherein the resin of resin layer with reinforcement (3) is selected from the group consisting of epoxy resins, cyanate ester resins, bismaleimide resins, bismaleide triazine resins, benzoxazine resins, and mixtures thereof.

6. The composite build-up material according to any of the foregoing claims wherein the reinforcement (6) in the resin layer with reinforcement (3) is selected from the group consisting of silica glass, silica glass containing metal oxides of group 1 metals, silica glass containing metal oxides of group 2 metals, silica glass containing metal oxides of group 1 and group 2 metals, E-glass, alumino silicates, silicon nitride, boron nitride, Wollastonite, ceramic oxides, aramides, and mixtures thereof.

7. The composite build-up material according to any of the foregoing claims wherein the composite build-up material has a layer sequence in the following order:
(i) a carrier layer (1) having a thickness of 1 to 200 µm
(ii) b) a release layer (4)
(ii) a resin layer without reinforcement (2) having a thickness of 1 to 150 µm and
(iii) a resin layer with reinforcement (3) having a thickness of 1 to 200 µm.

8. The composite build-up material according to claims 1 to 8 wherein the composite build-up material has a layer sequence in the following order:
(i) a carrier layer (1) having a thickness of 1 to 200 µm
(ii) b) a primer layer (5)
(ii) a resin layer without reinforcement (2) having a thickness of 1 to 150 µm and
(iii) a resin layer with reinforcement (3) having a thickness of 1 to 200 µm.

9. The composite build-up material according to any of the foregoing claims further containing a second resin layer without reinforcement (7) attached to the resin layer with reinforcement (3).

10. The composite build-up material according to any of the foregoing claims wherein an circuitry (9) is embedded into the resin layer without reinforcement (2).

11. Method of preparing a composite build-up material according to any of the foregoing claims wherein the resin layer without reinforcement (2) is deposited onto the carrier layer (1) from a solvent-free resin powder.

12. Method according to claim 12 wherein the solvent-free resin powder is deposited onto the carrier layer (1) by a method selected from the group consisting of electromagnetic brush process, powder scattering process and direct melt extrusion process.

13. Method according to any of the foregoing claims wherein the resin layer with reinforcement (3) is deposited onto the resin layer without reinforcement (2) from a solvent-free resin powder.

14. Method according to claim 14 wherein the solvent free deposition method is selected from the group consisting of electromagnetic brush process, powder scattering and direct melt extrusion.
